(19) Europäisches Patentamt / European Patent Office / Office européen des brevets

(11) **EP 3 813 136 A1**

(12) **EUROPEAN PATENT APPLICATION**
published in accordance with Art. 153(4) EPC

(43) Date of publication:
**28.04.2021 Bulletin 2021/17**

(51) Int Cl.:
***H01L 51/44*** *(2006.01)*

(21) Application number: **18923645.8**

(22) Date of filing: **19.06.2018**

(86) International application number:
**PCT/JP2018/023251**

(87) International publication number:
**WO 2019/244234 (26.12.2019 Gazette 2019/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(71) Applicants:
• **Kao Corporation**
**Chuo-ku,**
**Tokyo 103-8210 (JP)**
• **NATIONAL INSTITUTE OF ADVANCED INDUSTRIAL SCIENCE AND TECHNOLOGY**
**Chiyoda-ku**
**Tokyo 100-8921 (JP)**

(72) Inventors:
• **SAWADA,Takuya**
**Wakayama-shi, Wakayama 640-8580 (JP)**
• **SATO,Haruyuki**
**Wakayama-shi, Wakayama 640-8580 (JP)**
• **NAKAJIMA,Tomohiko**
**Tsukuba-shi, Ibaraki 305-8560 (JP)**
• **TSUCHIYA,Tetsuo**
**Tsukuba-shi, Ibaraki 305-8560 (JP)**

(74) Representative: **Hoffmann Eitle**
**Patent- und Rechtsanwälte PartmbB**
**Arabellastraße 30**
**81925 München (DE)**

(54) **LAYERED PEROVSKITE, LIGHT-ABSORBING LAYER, LIGHT-ABSORBING-LAYER-EQUIPPED SUBSTRATE, PHOTOELECTRIC CONVERSION ELEMENT, AND SOLAR CELL**

(57) The present invention provides: a layered perovskite that has a high band gap energy and an excellent carrier transport capacity; a light absorption layer containing the layered perovskite; a light-absorption-layer-equipped substrate and a photoelectric conversion element that have the light absorption layer; and a solar cell having the photoelectric conversion element. In the layered perovskite according to present invention, the inter-surface distance of (002) planes calculated from an X-ray diffraction peak obtained by an out-of-plane method is 2.6 to 5.0 nm, and, in the X-ray diffraction peak, an intensity ratio ((111) plane/(002) plane) of an X-ray diffraction peak intensity at a (111) plane with respect to an X-ray diffraction peak intensity at the (002) plane is 0.03 or more.

Fig.2

**Description**

TECHNICAL FIELD

The present invention relates to a layered perovskite, a light absorption layer containing the layered perovskite, a light-absorption-layer-equipped substrate and a photoelectric conversion element that have the light absorption layer, and a solar cell having the photoelectric conversion element.

BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

In recent years, an organic-inorganic hybrid perovskite solar cell comprising a perovskite compound having a three-dimensional structure (hereinafter, referred to as a three-dimensional perovskite) as a photoelectric conversion layer has been attracting attention as a solar cell replacing a silicon solar cell. At present, the conversion efficiency of the cell of the perovskite solar cell exceeds 20%, and its modularization and durability evaluation are being promoted.

However, since the three-dimensional perovskite has a low moisture resistance and an unstable structure, further improvement in durability is desired, and development of a new composition and manufacturing method for that purpose is required. Furthermore, when applying a perovskite solar cell to a next-generation high-efficiency solar cell such as a tandem solar cell or an intermediate band solar cell for the purpose of utilizing a specific light wavelength region, a high open circuit voltage cannot be obtained with a generally used three-dimensional perovskite having a band gap energy of about 1.5 to 1.6 eV. Thus, a perovskite compound having a larger band gap energy, specifically, a band gap energy exceeding 2 eV, is required.

A research on layered perovskites using a hydrophobic alkylammonium as a monovalent cation is underway as a perovskite that has both a moisture resistance and a large band gap energy.

For example, it has been reported that a layered perovskite using butylammonium $((C_4H_9NH_3)_2(CH_3NH_3)_{n-1}Pb_nI_{3n+1}$: n = 1 to 4; when n = 1, the number of layers is 1; when n = 2, the number of layers is 2; when n = 3, the number of layers is 3; and when n = 4, the number of layers is 4) has a more improved moisture resistance as compared with the three-dimensional perovskite (JACS 2015, 137, 7843-7850).

Further, for the purpose of realizing a high carrier mobility in a two-dimensional perovskite, a technique for forming a two-dimensional perovskite on a surface in which ammonium halide groups are arranged has been proposed (WO 2017/086337).

In addition, an organic-inorganic composite material for a solar cell including a layered perovskite-type structure having a composition containing fullerene $C_{60}$ has been proposed (JP-A-2016-63090).

Furthermore, a photoelectric conversion layer made of a layered organic perovskite material that selectively absorbs light only in a specific wavelength region has been proposed (JP-A-2017-5196).

However, the monolayer type $(C_4H_9NH_3)_2PbI_4$ having the largest band gap energy (2.24 eV) described in the JACS does not have a crystal orientation advantageous for carrier transport, so that the short-circuit current density is small, resulting in causing a problem that the conversion efficiency of the solar cell is low.

Further, the two-dimensional perovskite and the layered perovskite described in the respective patent documents also have a problem that the short-circuit current density is small and the conversion efficiency of the solar cell is low because the perovskites do not have a crystal orientation advantageous for carrier transport.

SUMMARY OF THE INVENTION

The present invention provides: a layered perovskite that has a high band gap energy and an excellent carrier transport capacity; a light absorption layer containing the layered perovskite; a light-absorption-layer-equipped substrate and a photoelectric conversion element that have the light absorption layer; and a solar cell having the photoelectric conversion element.

The present inventors have found that a carrier transport capacity is improved by using a layered perovskite having a specific crystal orientation.

That is, the present invention is related to a layered perovskite, wherein an inter-surface distance of (002) planes calculated from an X-ray diffraction peak obtained by an out-of-plane method is 2.6 nm or more and 5.0 nm or less, and, in the X-ray diffraction peak, an intensity ratio ((111) plane/(002) plane) of an X-ray diffraction peak intensity at a (111) plane with respect to an X-ray diffraction peak intensity at the (002) plane is 0.03 or more.

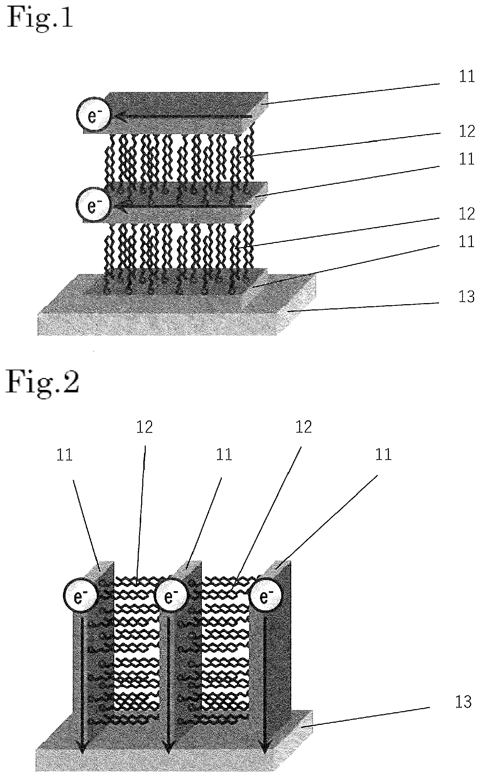

As shown in Fig. 1, a conventional layered perovskite has a structure in which a charge transport layer 11 composed of a metal cation and an anion of perovskite is laminated in multiple layers via an organic layer 12 composed of a cation of perovskite. Since the charge transport layer 11 is oriented parallel to an electrode substrate 13 (having a diffraction peak on the (002) plane at the X-ray diffraction peak), the electrons and holes generated by the photoelectric conversion can move only in the plane of the charge transport layer 11. Thus, it is considered that the short-circuit current density becomes reduced because the electrons and holes generated in the charge transport layer 11 cannot be sufficiently taken out.

On the other hand, as shown in Fig. 2, the layered perovskite of the present invention has a charge transport layer 11 oriented in the direction perpendicular to an electrode substrate 13 (having a diffraction peak on the (111) plane at the X-ray diffraction peak) unlike the conventional layered perovskite, and the electrons and holes generated by the photoelectric conversion can move in the plane of the charge transport layer 11 in the direction of the electrode substrate 13, so that the electrons and holes generated in the charge transport layer 11 can be taken out efficiently. Therefore, it is considered that the short-circuit current density becomes large and the photoelectric conversion efficiency and the quantum efficiency of a solar cell are improved.

Since the layered perovskite of the present invention is excellent in a carrier transport capacity, if the layered perovskite of the present invention is used as a light absorption layer, a photoelectric conversion element and a solar cell that have an excellent photoelectric conversion efficiency and an excellent quantum efficiency can be obtained.

BRIEF DESCRIPTION OF THE DRAWINGS

Fig. 1 is a schematic view showing a structure of a conventional layered perovskite.
Fig. 2 is a schematic view showing a structure of the layered perovskite of the present invention.
Fig. 3 is a schematic cross-sectional view showing an example of a structure of the photoelectric conversion element of the present invention.

DISCLOSURE OF THE INVENTION

<Layered Perovskite>

In the layered perovskite of the present invention, an inter-surface distance of (002) planes calculated from an X-ray diffraction peak obtained by an out-of-plane method is 2.6 nm or more and 5.0 nm or less, and, in the X-ray diffraction peak, an intensity ratio ((111) plane/(002) plane) of an X-ray diffraction peak intensity at a (111) plane with respect to an X-ray diffraction peak intensity at the (002) plane is 0.03 or more.

The inter-surface distance of (002) planes is preferably 2.7 nm or more, more preferably 2.8 nm or more, still more preferably 2.9 nm or more, from the viewpoint of improving the vertical orientation of the layered perovskite with respect to the substrate surface, and is preferably 4.7 nm or less, more preferably 4.4 nm or less, still more preferably 4.1 nm or less, even still more preferably 3.3 nm or less, from the viewpoint of improving the absorbance.

The intensity ratio ((111) plane/(002) plane) is 0.03 or more, preferably 0.05 or more, more preferably 0.07 or more, still more preferably 0.1 or more, even still more preferably 0.2 or more, further preferably 0.3 or more, furthermore preferably 0.5 or more, still furthermore preferably 1.0 or more.

The layered perovskite of the present invention may be any of a monolayer type, a bilayer type, a trilayer type, or a tetralayer type, but from the viewpoint of improving the vertical orientation of the layered perovskite with respect to the substrate surface and obtaining a large band gap energy, a monolayer type or a bilayer type is preferable and a monolayer type is more preferable.

The perovskite compound forming the layered perovskite is a compound having a perovskite-type crystal structure, and a known compound can be used. The band gap energy of the perovskite compound is preferably 2.0 eV or more, more preferably 2.2 eV or more, still more preferably 2.4 eV or more, from the viewpoint of improving the photoelectric conversion efficiency. From the viewpoint of absorbing light in a specific wavelength range, the band gap energy of the perovskite compound is preferably 3.5 eV or less, more preferably 3.2 eV or less, still more preferably 3.0 eV or less. The perovskite compound may be used alone or in combination of two or more compounds having different band gap energies.

Examples of the perovskite compound include a compound represented by the following general formula (1), which is a raw material for a monolayer type layered perovskite:

$$R_2MX^1{}_nX^2{}_{4-n} \qquad (1)$$

wherein R is a monovalent cation, two Rs are identical to each other, M is a divalent metal cation, $X^1$ and $X^2$ are each independently a monovalent anion, and n is an average number of moles of $X^1$, and n is a real number of 0 or more and 4 or less.

The R is a monovalent cation, for example, a cation of the group 1 of the periodic table and an organic cation. Examples of the cation of the group 1 of the periodic table include $Li^+$, $Na^+$, $K^+$, and $Cs^+$. Examples of the organic cation include an ammonium ion having a substituent and a phosphonium ion having a substituent. Such substituents are not particularly limited so far as the layered perovskite can be provided with vertical orientation with respect to the substrate surface. Examples of the substituted ammonium ion include an alkylammonium ion, a formamidinium ion and an arylammonium ion, and from the viewpoint of facilitating the control of the inter-surface distance of (002) planes of the layered perovskite and improving the vertical orientation of the layered perovskite with respect to the substrate surface, an alkylammonium ion is preferable, and a monoalkylammonium ion is more preferable.

The number of carbon atoms of the alkyl group of the alkylammonium ion is not particularly limited, but is preferably 14 or more, more preferably 16 or more, still more preferably 18 or more, from the viewpoint of facilitating the adjustment of the inter-surface distance of (002) planes of the layered perovskite to 2.6 nm or more and improving the vertical orientation of the layered perovskite with respect to the substrate surface. From the viewpoint of facilitating the adjustment of the inter-surface distance of (002) planes of the layered perovskite to 5.0 nm or less and improving the absorbance, the number of carbon atoms of the alkyl group of the alkylammonium ion is preferably 30 or less, more preferably 28 or less, still more preferably 26 or less, even still more preferably 24 or less.

The M is a divalent metal cation and includes, for example, $Pb^{2+}$, $Sn^{2+}$, $Hg^{2+}$, $Cd^{2+}$, $Zn^{2+}$, $Mn^{2+}$, $Cu^{2+}$, $Ni^{2+}$, $Fe^{2+}$, $Co^{2+}$, $Pd^{2+}$, $Ge^{2+}$, $Y^{2+}$, and $Eu^{2+}$. The M is preferably one or more selected from the group consisting of $Pb^{2+}$, $Sn^{2+}$, and $Ge^{2+}$, more preferably one or more selected from the group consisting of $Pb^{2+}$ and $Sn^{2+}$, and is still more preferably $Pb^{2+}$, from the viewpoint of obtaining a perovskite compound having a desired band gap energy.

The $X^1$ and $X^2$ are each independently a monovalent anion, and from the viewpoint of obtaining a perovskite compound having a desired band gap energy, a fluoride anion, a chloride anion, a bromide anion, or an iodide anion is preferable; a chloride anion, a bromide anion, or an iodide anion is more preferable; and a bromide anion or an iodide anion is still more preferable.

Examples of the compound represented by the general formula (1) having a band gap energy of 2.0 eV or more and 3.5 eV or less include $(C_{16}H_{33}NH_3)_2PbBr_4$, $(C_{16}H_{33}NH_3)_2PbI_4$, $(C_{16}H_{33}NH_3)_2PbI_nBr_{4-n}$, $(C_{18}H_{37}NH_3)_2PbBr_4$, $(C_{18}H_{37}NH_3)_2PbI_nBr_{4-n}$, $(C_{18}H_{37}NH_3)_2PbI_4$, $(C_{20}H_{41}NH_3)_2PbBr_4$, $(C_{20}H_{41}NH_3)_2PbI_4$, $(C_{20}H_{41}NH_3)_2PbI_nBr_{4-n}$, $(C_{22}H_{45}NH_3)_2PbBr_4$, $(C_{22}H_{45}NH_3)_2PbI_4$, $(C_{22}H_{45}NH_3)_2PbI_nBr_{4-n}$, $(C_{24}H_{49}NH_3)_2PbBr_4$, $(C_{24}H_{49}NH_3)_2PbI_4$, $(C_{24}H_{49}NH_3)_2PbI_nBr_{4-n}$, $(C_{26}H_{53}NH_3)_2PbBr_4$, $(C_{26}H_{53}NH_3)_2PbI_4$, $(C_{26}H_{53}NH_3)_2PbI_nBr_{4-n}$, $(C_{28}H_{57}NH_3)_2PbBr_4$, $(C_{28}H_{57}NH_3)_2PbI_4$, $(C_{28}H_{57}NH_3)_2PbI_nBr_{4-n}$, $(C_{30}H_{61}NH_3)_2PbBr_4$, $(C_{30}H_{61}NH_3)_2PbI_4$, and $(C_{30}H_{61}NH_3)_2PbI_nBr_{4-n}$. These compounds may be used alone or in combination of two or more thereof. Of these, from the viewpoint of improving the photoelectric conversion efficiency and the vertical orientation of the layered perovskite with respect to the substrate surface, $(C_{16}H_{33}NH_3)_2PbI_4$, $(C_{16}H_{33}NH_3)_2PbI_nBr_{4-n}$, and $(C_{18}H_{37}NH_3)_2PbI_4$ are preferable, and $(C_{16}H_{33}NH_3)_2PbI_4$ is more preferable.

The method for forming the layered perovskite of the present invention is not particularly limited. For example, a so-called wet process in which a dispersion containing the perovskite compound or a precursor thereof is prepared and the prepared dispersion is applied to the surface of a substrate (for example, an electrode substrate) and then dried is preferable.

Examples of the precursor of the perovskite compound include a combination of a compound represented by $MX^1_2$ and a compound represented by $RNH_3X^1$ when the perovskite compound is a compound represented by the general formula (1) .

The concentration of the perovskite compound or its precursor in the dispersion is not particularly limited and may be adjusted as appropriate, but is preferably 35% by mass or more, more preferably 40% by mass or more, still more preferably 45% by mass or more, from the viewpoint of improving the vertical orientation of the layered perovskite with respect to the substrate surface. From the viewpoint of solubility, the concentration of the perovskite compound or its precursor in the dispersion is preferably 75% by mass or less, more preferably 70% by mass or less, still more preferably 65% by mass or less.

The substrate is not particularly limited, but the surface free energy of the substrate calculated by using the Owens-Wendt equation is preferably 40 mJ/m$^2$ or more, more preferably 50 mJ/m$^2$ or more, still more preferably 60 mJ/m$^2$ or more, and is preferably 100 mJ/m$^2$ or less, more preferably 95 mJ/m$^2$ or less, still more preferably 90 mJ/m$^2$ or less, from the viewpoint of improving the vertical orientation of the layered perovskite with respect to the substrate surface.

Examples of the method of adjusting the surface free energy of a substrate to 40 mJ/m$^2$ or more and 100 mJ/m$^2$ or less include a method of providing a base layer containing a metal oxide (e.g. titanium oxide, nickel oxide, zinc oxide, tin oxide, vanadium oxide, etc.), and a copper compound (e.g. copper iodide, copper (I) thiocyanate, etc.); and an organic compound (e.g. poly(styrene sulfonic acid)(PSS), PSS-doped poly(3,4-ethylenedioxythiophene) (PEDOT:PSS), 2,2',7,7'-tetrakis(N,N-di-p-methoxy-phenylamino)-9,9'-spirobifluorene (Spiro-OMeTAD), poly[bis(4-phenyl)(2,4,6-triphenylmethyl)amine] (PTAA), poly(3-hexylthiophene-2,5-diyl)(P3HT), [6,6]-phenyl-C61-butyric acid methyl ester (PCBM), [6,6]-phenyl-C61-butyric acid n-octyl ester (PCBO), and [6,6]-phenyl-C61-butyric acid butyl ester (PCBB), on the surface of the substrate.

The method for forming the layered perovskite of the present invention will be described in detail in the following method for manufacturing a photoelectric conversion element.

<Light Absorption Layer>

The light absorption layer contributes to charge separation of a photoelectric conversion element and has a function of transporting electrons and holes generated by light absorption toward electrodes in opposite directions and is also called a charge separation layer or a photoelectric conversion layer.

The light absorption layer of the present invention contains the layered perovskite as a light absorbing agent. The light absorption layer of the present invention may contain a light absorbing agent other than the layered perovskite so far as the effects of the present invention are not impaired. Examples of the light absorbing agent other than the layered perovskite include quantum dots.

The quantum dots have a band gap energy of 0.2 eV or more and less than the band gap energy of the layered perovskite from the viewpoint of complementing the band gap energy which the layered perovskite does not have and improving the photoelectric conversion efficiency in the near infrared light region. The quantum dots may be used singly or in combination of two or more kinds having different band gap energies.

From the viewpoint of improving stability and photoelectric conversion efficiency, the particle size of the quantum dots is preferably 1 nm or more, more preferably 2 nm or more, still more preferably 2.3 nm or more, and from the viewpoint of improving film forming property and photoelectric conversion efficiency, the particle size of the quantum dots is preferably 20 nm or less, more preferably 10 nm or less, still more preferably 5 nm or less. The particle size of the quantum dots can be measured by a conventional method such as crystallite diameter analysis of XRD (X-ray diffraction) or transmission electron microscope observation.

A known quantum dots can be used without particular limitation. Examples of the quantum dots having such a band gap energy include metal oxides, metal chalcogenides (such as sulfides, selenides, and tellurides), specifically PbS, PbSe, PbTe, CdS, CdSe, CdTe, $Sb_2S_3$, $Bi_2S_3$, $Ag_2S$, $Ag_2Se$, $Ag_2Te$, $Au_2S$, $Au_2Se$, $Au_2Te$, $Cu_2S$, $Cu_2Se$, $Cu_2Te$, $Fe_2S$, $Fe_2Se$, $Fe_2Te$, $In_2S_3$, SnS, SnSe, SnTe, $CuInS_2$, $CuInSe_2$, $CuInTe_2$, EuS, EuSe, and EuTe. From the viewpoint of excellent durability (oxidation resistance) and photoelectric conversion efficiency, the quantum dot preferably contains Pb element, more preferably PbS or PbSe, still more preferably PbS.

The thickness of the light absorption layer is not particularly limited, but is preferably 30 nm or more, more preferably 50 nm or more, still more preferably 80 nm or more, from the viewpoint of increasing light absorption to improve photoelectric conversion efficiency, and preferably 3000 nm or less, more preferably 1500 nm or less, still more preferably 1000 nm or less, even still more preferably 500 nm or less, from the viewpoint of improving photoelectric conversion efficiency by improving carrier transfer efficiency to a hole transport material layer and an electron transport material layer. The thickness of the light absorption layer can be measured by a measuring method such as electron microscope observation of the cross section of the film.

<Photoelectric Conversion Element>

The photoelectric conversion element of the present invention has the light absorption layer (the layered perovskite). In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

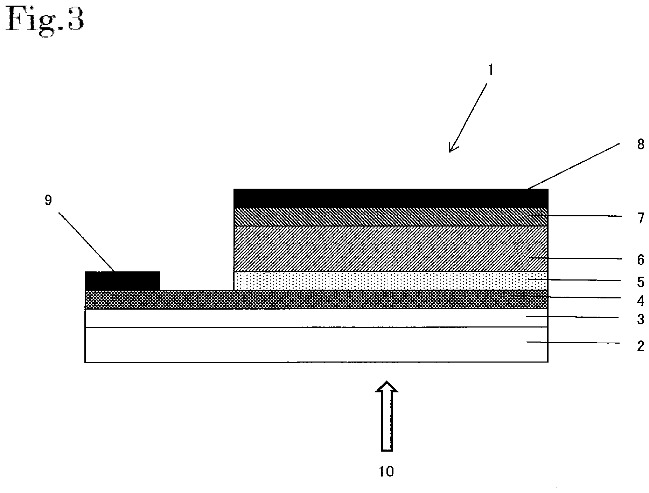

Hereinafter, the structure and manufacturing method of the photoelectric conversion element of the present invention will be described with reference to Fig. 3, but Fig. 3 is only an example of a forward structure type and the structure may be a reverse structure type in which a hole transport layer is used as a base layer of the light absorption layer. The configuration of the photoelectric conversion element of the present invention is not limited to the mode shown in Fig. 3.

Fig. 3 is a schematic sectional view showing an example of a structure of a photoelectric conversion element of the present invention. A photoelectric conversion element 1 has a structure in which a transparent substrate 2, a transparent conductive layer 3, a blocking layer 4, an electron extraction layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used for such a purpose. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide ($SnO_2$), indium zinc oxide (IZO), zinc oxide (ZnO), a polymer material having high conductivity and the like can be mentioned. Examples of the polymer material include polyacetylene type polymer materials, polypyrrole type polymer materials, polythiophene type polymer materials, and polyphenylenevinylene type polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The electron extraction layer 5 is a layer having a function of supporting the light absorption layer 6 on its surface. In order to increase the light absorption efficiency in the solar cell, it is preferable to increase the surface area of the portion receiving light. By providing the electron extraction layer 5, it is possible to increase the surface area of such a light-receiving portion.

Examples of the material of the electron extraction layer 5 include a metal oxide, a metal chalcogenide (for example, a sulfide and a selenide), a compound having a perovskite type crystal structure (excluding the light absorber described above), a silicon oxide (for example, silicon dioxide and zeolite), a fullerene derivative, and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite type crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

Examples of the fullerene derivative include [6,6]-phenyl-C61-butyric acid methyl ester (PCBM), [6,6]-phenyl-C61-butyric acid n-octyl ester (PCBO), and [6,6]-phenyl-C61-butyric acid butyl ester (PCBB).

The electron extraction layer 5 can be formed from a raw material solution of the forming material or fine particles of the forming material. The fine particles of the material for forming the electron extraction layer 5 are preferably used as a dispersion containing the fine particles. Examples of the method for forming the electron extraction layer 5 include a wet method, a dry method, and other methods (for example, the method described in Chemical Review, Vol. 110, p. 6595 (2010)). In these methods, it is preferable to apply the raw material solution or dispersion (sol or paste) of the material for forming the electron extraction layer 5 on the surface of the blocking layer 4 and then dry or calcine the raw material solution or dispersion. The fine particles can be brought into close contact with each other by drying or calcination. Examples of the coating method include a gravure coating method, a bar coating method, a printing method, a spraying method, a spin coating method, a dipping method, and a die coating method.

From the viewpoint of improving the vertical orientation of the layered perovskite serving as the light absorption layer with respect to the surface of the electron extraction layer 5, the surface free energy of the electron extraction layer 5 calculated by using the Owens-Wendt equation is preferably 40 mJ/m$^2$ or more, more preferably 50 mJ/m$^2$ or more, still more preferably 60 mJ/m$^2$ or more, and is preferably 100 mJ/m$^2$ or less, more preferably 95 mJ/m$^2$ or less, still more preferably 90 mJ/m$^2$ or less.

As a method of adjusting the surface free energy of the electron extraction layer 5 to 40 mJ/m$^2$ or more and 100 mJ/m$^2$ or less, for example, there is exemplified a method using a metal oxide such as titanium oxide, zinc oxide, and tin oxide, or a fullerene derivative as a material for forming the electron extraction layer 5.

The light absorption layer 6 is the above-described Light absorption layer of the present invention. A method of forming the light absorption layer 6 is not particularly limited, and, for example, there is preferably mentioned a method based on a so-called wet process in which a dispersion containing the perovskite compound or its precursor is prepared and the prepared dispersion is coated on the surface of the electron extraction layer 5, and is dried.

In the wet process, the dispersion containing the perovskite compound or its precursor preferably contains a solvent in view of film-forming property, cost, storage stability, and excellent performance (for example, photoelectric conversion characteristics). Examples of the solvent include esters (methyl formate, ethyl formate, etc.), ketones ($\gamma$-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide type solvents (N,N-dimethylformamide, acetamide, N,N-dimethylacetamide, etc.), nitrile type solvents (acetonitrile, isobutyronitrile, propionitrile, methoxyacetonitrile etc.), carbonate type solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide type solvents, and dimethylsulfoxide (DMSO), still more preferably amide type solvents, even still more preferably N,N-dimethylformamide, from the viewpoints of film forming properties, cost, storage stability, and expression of excellent performance (for example, photoelectric conversion characteristics).

The concentration of the perovskite compound or its precursor in the dispersion is not particularly limited and may be adjusted as appropriate, but is preferably 35% by mass or more, more preferably 40% by mass or more, still more preferably 45% by mass or more, from the viewpoint of improving the vertical orientation of the layered perovskite with respect to the surface of the electron extraction layer 5, and is preferably 75% by mass or less, more preferably 70% by mass or less, still more preferably 65% by mass or less, from the viewpoint of solubility.

The method for preparing the dispersion is not particularly limited. The specific preparation method is as described in Examples.

The coating method in the wet process is not particularly limited, and examples thereof include a gravure coating method, a bar coating method, a printing method, a spraying method, a spin coating method, a dipping method, and a die coating method.

As a drying method in the wet process, for example, a thermal drying, an air stream drying, a vacuum drying and the like can be mentioned, from the viewpoints of ease of production, cost, and expression of excellent performance (for example, photoelectric conversion characteristics), and the thermal drying is preferable. The temperature of the thermal drying is preferably 40°C or more, more preferably 60°C or more, still more preferably 70°C or more, from the viewpoint of expression of excellent performance (e.g. photoelectric conversion characteristics), and preferably 200°C or less, more preferably 150°C or less, still more preferably 120°C or less, from the same viewpoint and in view of cost. The time for thermal drying is preferably 1 minute or more, more preferably 5 minutes or more, still more preferably 10 minutes or more, from the viewpoint of expression of excellent performance (for example, photoelectric conversion characteristics), and preferably 120 minutes or less, more preferably 60 minutes or less, still more preferably 30 minutes or less, from the same viewpoint and in view of cost.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, copper iodide, copper thiocyanate and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

The light absorption layer 6 may be formed on the surface of the hole transport layer 7 instead of being formed on the surface of the electron extraction layer 5. In the case of this structure, the hole transport layer 7 is formed on the surface of the transparent conductive layer 3 without forming the blocking layer 4. The method of forming the light absorption layer 6 on the surface of the hole transport layer 7 is not particularly limited, and examples thereof include a method by the wet process.

From the viewpoint of improving the vertical orientation of the layered perovskite serving as the light absorption layer with respect to the surface of the hole transport layer 7, the surface free energy of the hole transport layer 7 calculated using the Owens-Wendt equation is preferably 40 mJ/m$^2$ or more, more preferably 50 mJ/m$^2$ or more, still more preferably 60 mJ/m$^2$ or more, and is preferably 100 mJ/m$^2$ or less, more preferably 95 mJ/m$^2$ or less, still more preferably 90 mJ/m$^2$ or less.

As a method for adjusting the surface free energy of the hole transport layer 7 to 40 mJ/m$^2$ or more and 100 mJ/m$^2$ or less, there is exemplified a method using, as materials for forming the hole transport layer 7, poly(styrene sulfonic acid)(PSS), PSS-doped poly(3,4-ethylenedioxythiophene)(PEDOT:PSS), 2,2',7,7'-tetrakis(N,N-di-p-methoxy-phenylamino)-9,9'-spirobifluorene (Spiro-OMeTAD), poly[bis(4-phenyl)(2,4,6-triphenylmethyl)amine] (PTAA), copper iodide, copper thiocyanate and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

<Solar Cell>

The solar cell of the present invention has the photoelectric conversion element. In the solar cell of the present invention, the configuration other than the light absorption layer is not particularly limited, and a known solar cell configuration can be applied.

The present invention and preferred embodiments of the present invention are described below.

<1> A layered perovskite, wherein an inter-surface distance of (002) planes calculated from an X-ray diffraction peak obtained by an out-of-plane method is 2.6 nm or more and 5.0 nm or less, and, in the X-ray diffraction peak, an intensity ratio ((111) plane/(002) plane) of an X-ray diffraction peak intensity at a (111) plane with respect to an X-ray diffraction peak intensity at the (002) plane is 0.03 or more.

<2> The layered perovskite according to <1>, wherein the inter-surface distance of (002) planes is preferably 2.7 nm or more, more preferably 2.8 nm or more, still more preferably 2.9 nm or more, and is preferably 4.7 nm or less, more preferably 4.4 nm or less, still more preferably 4.1 nm or less, even still more preferably 3.3 nm or less.

<3> The layered perovskite according to <1> or <2>, wherein the intensity ratio ((111) plane/(002) plane) is preferably 0.05 or more, more preferably 0.07 or more, still more preferably 0.1 or more, even still more preferably 0.2 or more, further preferably 0.3 or more, furthermore preferably 0.5 or more, still furthermore preferably 1.0 or more.

<4> The layered perovskite according to <1>, wherein

preferably, the inter-surface distance of (002) planes is 2.7 nm or more and 4.7 nm or less, and the intensity ratio ((111) plane/(002) plane) is 0.05 or more,

more preferably, the inter-surface distance of (002) planes is 2.8 nm or more and 4.4 nm or less, and the intensity ratio ((111) plane/(002) plane) is 0.07 or more,

still more preferably, the inter-surface distance of (002) planes is 2.9 nm or more and 4.1 nm or less, and the intensity ratio ((111) plane/(002) plane) is 0.1 or more,

even still more preferably, the inter-surface distance of (002) planes is 2.9 nm or more and 3.3 nm or less, and the intensity ratio ((111) plane/(002) plane) is 0.2 or more.

<5> The layered perovskite according to any one of <1> to <4>, wherein the layered perovskite is preferably a monolayer type or a bilayer type, more preferably a monolayer type.

<6> The layered perovskite according to any one of <1> to <5>, wherein the band gap energy of the perovskite compound forming the layered perovskite is preferably 2.0 eV or more, more preferably 2.2 eV or more, still more preferably 2.4 eV or more, and is preferably 3.5 eV or less, more preferably 3.2 eV or less, still more preferably 3.0 eV or less.

<7> The layered perovskite according to <1>, wherein

preferably, the inter-surface distance of (002) planes is 2.7 nm or more and 4.7 nm or less, the intensity ratio ((111) plane/(002) plane) is 0.05 or more, and the band gap energy of the perovskite compound forming the layered perovskite is 2.0 eV or more and 3.5 eV or less,

more preferably, the inter-surface distance of (002) planes is 2.8 nm or more and 4.4 nm or less, the intensity ratio ((111) plane/(002) plane) is 0.07 or more, and the band gap energy of the perovskite compound forming the layered perovskite is 2.2 eV or more and 3.2 eV or less,

still more preferably, the inter-surface distance of (002) planes is 2.9 nm or more and 4.1 nm or less, the intensity ratio ((111) plane/(002) plane) is 0.1 or more, and the band gap energy of the perovskite compound forming the layered perovskite is 2.4 eV or more and 3.0 eV or less,

even still more preferably, the inter-surface distance of (002) planes is 2.9 nm or more and 3.3 nm or less, the intensity ratio ((111) plane/(002) plane) is 0.2 or more, and the band gap energy of the perovskite compound forming the layered perovskite is 2.4 eV or more and 3.0 eV or less.

<8> The layered perovskite according to any one of <1> to <7>, containing a compound represented by the following general formula (1):

$$R_2MX^1{}_nX^2{}_{4-n} \qquad (1)$$

wherein R is a monovalent cation, two Rs are identical to each other, M is a divalent metal cation, $X^1$ and $X^2$ are each independently a monovalent anion, and n is an average number of moles of $X^1$, and n is a real number of 0 or more and 4 or less.

<9> The layered perovskite according to <8>, wherein R is preferably an alkylammonium ion, a formamidinium ion or an arylammonium ion, more preferably an alkylammonium ion, still more preferably a monoalkylammonium ion.

<10> The layered perovskite according to <9>, wherein the number of carbon atoms of the alkyl group of the alkylammonium ion is preferably 14 or more, more preferably 16 or more, still more preferably 18 or more, and is preferably 30 or less, more preferably 28 or less, still more preferably 26 or less, even still more preferably 24 or less.

<11> The layered perovskite according to any one of <8> to <10>, wherein the M is preferably one or more selected from the group consisting of $Pb^{2+}$, $Sn^{2+}$, and $Ge^{2+}$, more preferably one or more selected from the group consisting of $Pb^{2+}$ and $Sn^{2+}$, still more preferably $Pb^{2+}$,

<12> The layered perovskite according to any one of <8> to <11>, wherein the $X^1$ and $X^2$ are each independently preferably a fluoride anion, a chloride anion, a bromide anion, or an iodide anion, more preferably a chloride anion, a bromide anion, or an iodide anion, still more preferably a bromide anion, or an iodide anion.

<13> The layered perovskite according to <8>, wherein the compound represented by the general formula (1) is preferably $(C_{16}H_{33}NH_3)_2PbI_4$, $(C_{16}H_{33}NH_3)_2PbI_nBr_{4-n}$ or $(C_{18}H_{37}NH_3)_2PbI_4$, more preferably $(C_{16}H_{33}NH_3)_2PbI_4$.

<14> A light absorption layer containing the layered perovskite according to any one of <1> to <13>.

<15> The light absorption layer according to <14>, wherein the thickness of the light absorption layer is preferably 30 nm or more, more preferably 50 nm or more, still more preferably 80 nm or more, and preferably 3000 nm or less, more preferably 1500 nm or less, still more preferably 1000 nm or less, even still more preferably 500 nm or less.

<16> A light-absorption-layer-equipped substrate, wherein the light absorption layer according to <14> or <15> is formed on a substrate.

<17> The light-absorption-layer-equipped substrate according to <16>, wherein the surface free energy of the substrate calculated by using the Owens-Wendt equation is preferably 40 mJ/m$^2$ or more, more preferably 50 mJ/m$^2$ or more, still more preferably 60 mJ/m$^2$ or more, and is preferably 100 mJ/m$^2$ or less, more preferably 95 mJ/m$^2$ or less, still more preferably 90 mJ/m$^2$ or less.

<18> A photoelectric conversion element having the light absorption layer according to <14> or <15>, or the light-absorption-layer-equipped substrate according to <16> or <17>.

<19> A solar cell having the photoelectric conversion element according to <18>.

EXAMPLES

Hereinafter, the present invention will be described specifically based on Examples. Unless otherwise indicated in the table, the content of each component is % by mass. In addition, the evaluation/measurement method are as follows. In addition, unless otherwise noted, the implementation and measurement were carried out at 25°C.

<Measurement Method of X-Ray Diffraction by Out-of-Plane Method>

A MiniFlexII manufactured by Rigaku Corporation was used as an X-ray diffractometer. The measurement conditions were as follows: Cu-K$\alpha$: 30 kV, 15 mA, sampling width: 0.02, divergence slit: 1.25 degrees, scattering slit: 8°, light receiving slit: open. Using the continuous scanning method with a scanning range of $2\theta$ = 2.5 to 30° and a scanning speed of 10°/min, diffraction peaks on the (002) and (111) planes were detected, and the inter-surface distance was calculated from the Bragg's equation ($\lambda = 2d \cdot \sin\theta$). In the Bragg's equation, $\lambda$ represents a wavelength of Cu-K$\alpha$, d represents an inter-surface distance, and $\theta$ represents a Bragg angle. Further, as the diffraction peak intensity, the photon count number (cps) at the peak top was adopted. The results are shown in Table 2.

<Calculation Method of Band Gap>

The band gap was calculated from the light absorption spectrum. A Solidspec-3700 spectrophotometer (manufactured by Shimadzu Corporation) was used for the light absorption spectrum measurement. The measurement was performed under the conditions of scan speed: medium speed, sample pitch: 1 nm, measurement wavelength range: 300 to 1000 nm, slit width: (20), detector unit: integrating sphere, and the band gap (1240/light absorption edge) was calculated from the absorption edge of the obtained light absorption spectrum. The results are shown in Table 2.

<Calculation Method of Surface Free Energy of Base Layer-Equipped Substrate>

A fully automatic contact angle meter: DM-SA (manufactured by Kyowa Interface Science Co., Ltd.) was used to measure a contact angle. Diiodomethane (Wako Pure Chemical Industries, Ltd., Wako First Class) of 1 μL was dropped onto each base layer-equipped substrate, and the contact angle after 7 seconds was measured by the θ/2 method. Similarly, for glycerin (manufactured by Wako Pure Chemical Industries, Ltd., Wako First Class), the contact angle after 100 seconds was measured. The surface free energy of each base layer was calculated from the contact angle of each liquid with respect to the base layer and the theoretical equation of Owens-Wendt shown in the following equation. The results are shown in Table 1.

$$\gamma_L{}^{total}(1 + \cos\theta) = 2(\gamma_S{}^d \times \gamma_L{}^d)^{0.5} + 2(\gamma_S{}^p \times \gamma_L{}^p)^{0.5}$$

wherein $\gamma_S{}^d$ and $\gamma_L{}^d$ represent solid and liquid dispersion components, respectively, and $\gamma_S{}^P$ and $\gamma_L{}^p$ represent solid and liquid polar components, respectively.

<Evaluation Method of Battery Performance and Quantum Efficiency>

Xenon lamp white light was used as a light source (Peccel Technologies, Inc.: PEC-L01), and a solar cell was masked so that the light (irradiation energy 100 mW/cm$^2$) hits only a specific area (area 0.0363 cm$^2$). Then, the current-voltage curve of the solar cell was measured. The measurement conditions were as follows: a measurement speed of 0.1 V/s (0.01 V step), a waiting time of 50 ms after voltage setting, a measurement integration time of 50 ms, a start voltage of -0.1 V, and an end voltage of 1.1 V. From the obtained current-voltage curve, the short-circuit current density (mA/cm$^2$), open circuit voltage (V), fill factor (ff), and conversion efficiency (%) were determined. In addition, the quantum efficiency (IPCE) was measured by using a spectral sensitivity measuring device (CEP-2000MLR manufactured by Bunkoukeiki Co., Ltd.) in a wavelength range of 400 nm to 800 nm at 10 nm intervals under a mask having a light irradiation area of 0.0363 cm$^2$. The quantum efficiency at a wavelength of 400 nm was determined. The results are shown in Table 3.

[Preparation of Base Layer-Equipped Substrate]

Production Example 1

(Preparation of Substrate 1 (Substrate in Which TiO$_2$ Porous Base Layer Is Formed on FTO Substrate))

(1) Cleaning of FTO Substrate (Cleaning with Detergent and Ozone Cleaning)

A FTO substrate (manufactured by AGC fabritech Co., Ltd., 1.8 mm thickness (25 mm x 25 mm)) was put into a glass container (capacity: 600 mL). The container was filled with 1 % by mass of neutral detergent (manufactured by Kao Corporation, 2 g of Kyukyutto (registered trademark) diluted with 198 g of ion-exchange water), 160 g of acetone (manufactured by Wako Pure Chemical Industries, Ltd., Wako first grade), 160 g of 2-propanol (manufactured by Wako Pure Chemical Industries, Ltd., Wako first grade), and 200 g of ion-exchange water, respectively. The ultrasonic cleaning was performed with each liquid for 10 minutes. Further, the FTO substrate was placed in an ozone generator (PC-450 UV ozone cleaner manufactured by Meiwafosis Co., Ltd.) and irradiated with UV for 30 minutes.

(2) Preparation of TiO$_2$ Porous Base Layer

Ethanol (1.41g, manufactured by Wako Pure Chemical Industries, Ltd., ultra-dehydrated) was added to 404 mg of PST-18NR (manufactured by JGC Catalysts and Chemicals Ltd.), and the mixture was stirred with a vortex mixer for 5 minutes, and then ultrasonically dispersed for 1 hour to obtain a suspension. The FTO substrate cleaned in the above (1) was set on a spin coater (MS-100 manufactured by Mikasa Co., Ltd.), dust was blown off with a blower, and 190 μL of the TiO$_2$ suspension was dropped with a micropipette and then spin-coated (slope 5 s, 5000 rpm/30 s, slope 5 s). After that, the FTO substrate was placed on a hot plate at 125°C and dried for 30 minutes. Then, the temperature was raised to 500°C over 1 hour and calcination was carried out for 30 minutes to prepare a substrate 1 (a substrate having a TiO$_2$ porous base layer formed on the FTO substrate).

Production Example 2

(Preparation of Substrate 2 (Substrate in Which PEDOT:PSS Base Layer Is Formed on FTO Substrate))

(1) Cleaning of FTO Substrate

The FTO substrate was cleaned in the same manner as in Production Example 1(1).

(2) Preparation of PEDOT:PSS Base Layer

The FTO substrate cleaned in the above (1) was set on a spin coater, dust was blown off with a blower, and 190 $\mu$L of a PEDOT:PSS dispersion (manufactured by Heraeus, product name Clevios P VP AI 4083) was dropped with a micropipette to perform a spin-coating (500 rpm/5 sec → 3000 rpm/30 sec). Then, the FTO substrate was placed on a hot plate at 120°C for 10 minutes and further dried at 150°C for 5 minutes to prepare a substrate 2 (a substrate having a PEDOT:PSS base layer formed on the FTO substrate).

Production Example 3

(Preparation of Substrate 3 (Substrate on Which Spiro-OMeTAD Base Layer Is Formed on FTO Substrate))

(1) Cleaning of FTO Substrate

The FTO substrate was cleaned in the same manner as in Production Example 1(1).

(2) Preparation of Spiro-OMeTAD Base Layer

Chlorobenzene (1 mL)(manufactured by Nacalai Tesque, Inc.) was added to 72.3 mg of Spiro-OMeTAD (manufactured by Wako Pure Chemical Industries, Ltd., 2,2',7,7'-tetrakis[N,N-di-p-methoxyphenylamino]-9,9'-spirobifluorene) to prepare a solution, and the prepared solution was filtered through a PTFE filter (0.45 ($\mu$m). The FTO substrate cleaned in the above (1) was set on a spin coater, dust was blown off with a blower, and 190 $\mu$L of the solution was dropped with a micropipette to perform a spin coating (slope 5 s, 4000 rpm/30 s, slope 5 s). Then, the FTO substrate was placed on a hot plate at 70°C and dried for 30 minutes to prepare a substrate 3 (a substrate having a Spiro-OMeTAD base layer formed on the FTO substrate).

[Preparation of Layered Perovskite]

Example 1

N,N-dimethylformamide (0.5 mL)(manufactured by Wako Pure Chemical Industries, Ltd., ultra-dehydrated, further dehydrated with molecular sieves) was added to a mixture of 369 mg of hexadecylammonium having 16 carbon atoms (a neutralized product of 98% hexadecylamine, manufactured by Sigma Aldrich with hydroiodic acid, manufactured by Wako Pure Chemical Industries, Ltd.) and 231 mg of $PbI_2$ (manufactured by Tokyo Chemical Industry Co., Ltd., lead (II) iodide, 99.99%, trace metals basis for perovskite precursor)), and the mixture was stirred on a hot stirrer at 70°C until dissolved. The substrate 1 prepared in Production Example 1 was set on a spin coater, dust was blown off with a blower, 150 $\mu$L of the prepared solution was added dropwise, and after waiting for 5 seconds, spin coating was performed (slope 5 s, 6500 rpm/5 s, slope 5 s). Immediately after the spin coating, the substrate 1 was placed on a hot plate at 70°C and dried for 30 minutes to form a layered perovskite (a light absorption layer containing $(C_{16}H_{33}NH_3)_2PbI_4$) on the substrate 1. The thickness of the obtained layered perovskite (light absorption layer) was about 2000 nm.

Example 2

A layered perovskite (a light absorption layer containing $(C_{16}H_{33}NH_3)_2PbI_4$) was formed on the substrate 2 in the same manner as in Example 1 except that the substrate 2 prepared in Production Example 2 was used instead of the substrate 1 prepared in Production Example 1. The thickness of the obtained layered perovskite (light absorption layer) was about 2000 nm.

Example 3

A layered perovskite (a light absorption layer containing $(C_{16}H_{33}NH_3)_2PbI_{3.2}Br_{0.8}$) was formed on the substrate 2 in the same manner as in Example 2 except that 138 mg of $PbI_2$ (manufactured by Tokyo Chemical Industry Co., Ltd., lead (II) iodide 99.99%, trace metals basis for perovskite precursor) and 73 mg of $PbBr_2$ (lead (II) bromide for perovskite precursor) were used instead of using $PbI_2$ (231 mg) .

Example 4

A layered perovskite (a light absorption layer containing $(C_{16}H_{33}NH_3)_2PbI_4$) was formed on the substrate 3 in the same manner as in Example 1 except that the substrate 3 prepared in Production Example 3 was used instead of the substrate 1 prepared in Production Example 1.

Example 5

A layered perovskite (a light absorption layer containing $(C_{18}H_{37}NH_3)_2PbI_4$) was formed on the substrate 1 in the same manner as in Example 1 except that 397 mg of octadecylammonium having 18 carbon atoms (a neutralized product of octadecylamine manufactured by Wako Pure Chemical Industries, Ltd. with hydroiodic acid manufactured by Wako Pure Chemical Industries, Ltd.) was used instead of using hexadecylammonium having 16 carbon atoms.

Example 6

A layered perovskite (a light absorption layer containing $(C_{18}H_{37}NH_3)_2PbI_4$) was formed on the substrate 2 in the same manner as in Example 5 except that the substrate 2 prepared in Production Example 2 was used instead of the substrate 1 prepared in Production Example 1.

Example 7

A layered perovskite (a light absorption layer containing $(C_{18}H_{37}NH_3)_2PbI_4$) was formed on the substrate 3 in the same manner as in Example 5 except that the substrate 3 prepared in Production Example 3 was used instead of the substrate 1 prepared in Production Example 1.

Comparative Example 1

A layered perovskite (a light absorption layer containing $(C_4H_9NH_3)_2PbI_4$) was formed on the substrate 1 in the same manner as in Example 1 except that 201 mg of butylamine hydroiodide having 4 carbon atoms (manufactured by Tokyo Chemical Industry Co., Ltd.) was used instead of using hexadecylammonium having 16 carbon atoms. The thickness of the obtained layered perovskite (light absorption layer) was about 660 nm.

Comparative Example 2

A layered perovskite (a light absorption layer containing $(C_4H_9NH_3)_2PbI_4$) was formed on the substrate 2 in the same manner as in Comparative Example 1 except that the substrate 2 prepared in Production Example 2 was used instead of the substrate 1 prepared in Production Example 1.

Comparative Example 3

A layered perovskite (a light absorption layer containing $(C_4H_9NH_3)_2PbI_4$) was formed on the substrate 3 in the same manner as in Comparative Example 1 except that the substrate 3 prepared in Production Example 3 was used instead of the substrate 1 prepared in Production Example 1.

Comparative Example 4

A layered perovskite (a light absorption layer containing $(C_8H_{17}NH_3)_2PbI_4$) was formed on the substrate 1 in the same manner as in Comparative Example 1 except that 257 mg of octylamine hydroiodide having 8 carbon atoms (a neutralized product of octylamine manufactured by Wako Pure Chemical Industries, Ltd., Wako special grade with hydroiodic acid manufactured by Wako Pure Chemical Industries, Ltd.) was used instead of using 201 mg of a butylamine hydroiodide having 4 carbon atoms (manufactured by Tokyo Chemical Industry Co., Ltd.). The thickness of the obtained layered perovskite (light absorption layer) was about 900 nm.

Comparative Example 5

A layered perovskite (a light absorption layer containing $(C_8H_{17}NH_3)_2PbI_4$) was formed on the substrate 2 in the same manner as in Comparative Example 4 except that the substrate 2 prepared in Production Example 2 was used instead of the substrate 1 prepared in Production Example 1.

Comparative Example 6

A layered perovskite (a light absorption layer containing $(C_8H_{17}NH_3)_2PbI_4$) was formed on the substrate 3 in the same manner as in Comparative Example 4 except that the substrate 3 prepared in Production Example 3 was used instead of the substrate 1 prepared in Production Example 1.

[Preparation of Solar Cell]

Example 8

A FTO substrate (manufactured by AGC fabritech Co., Ltd., 1.8 mm thickness (25 mm x 25 mm)) was put into a glass container (capacity: 600 mL). The container was filled with 1% by mass of a neutral detergent (manufactured by Kao Corporation, 2 g of Kyukyutto (registered trademark) diluted with 198 g of ion-exchange water), acetone (manufactured by Wako Pure Chemical Industries, Ltd., Wako first grade), 2-propanol (manufactured by Wako Pure Chemical Industries, Ltd., Wako first grade), and ion-exchange water, respectively. The ultrasonic cleaning was performed with each liquid for 10 minutes. Further, the FTO substrate was placed in an ozone generator (PC-450 UV ozone cleaner manufactured by Meiwafosis Co., Ltd.) and irradiated with UV for 30 minutes.
A heat-resistant glass was placed on a hot plate, and the above FTO substrate was arranged on the glass. After a mask (stainless steel plate having a width of 1 cm) was placed on the FTO surface to which the electrodes were attached, the FTO substrate was heated to 450°C. One milliliter of bis(2,4-pentanedionato)bis(2-propanolato)titanium (IV) (a 5% isopropyl alcohol solution manufactured by Tokyo Chemical Industry Co., Ltd.) was dissolved in 39 mL of ethanol (manufactured by Wako Pure Chemical Industries, Ltd.) to prepare a spray solution. The spray solution was sprayed at 0.3 MPa on the FTO substrate provided with a mask from a height of about 30 cm (spraying was repeated twice in 20 cm $\times$ 8 rows and the spray amount was about 21 to 24 g). Then, the FTO substrate was maintained at 450°C for 3 minutes. After performing this operation twice more, the FTO substrate was cooled to room temperature (20°C).
The hot stirrer was heated to 70°C in advance, and 100 mL of ice-cooled ion-exchange water and 440 $\mu$L of $TiCl_4$ (manufactured by Wako Pure Chemical Industries, Ltd.) were added to a polyethylene container to prepare a 50 mM $TiCl_4$ solution. The FTO substrate was immersed in the $TiCl_4$ solution, stirred for 30 minutes, and ice-cooled ion-exchange water (100 mL) was added. Then, the FTO substrate was taken out and washed with ion-exchange water. After removing water with an air gun, the temperature was raised to 500°C over 15 minutes and calcination was performed for 20 minutes to form a dense $TiO_2$ layer.
Ethanol (1.41 g, ultra-dehydrated, manufactured by Wako Pure Chemical Industries, Ltd.) was added to 404 mg of PST-18NR (manufactured by JGC Catalysts and Chemicals Ltd.), and the mixture was stirred with a vortex mixer for 5 minutes. The obtained $TiO_2$ suspension was ultrasonically dispersed for 1 hour. The FTO substrate on which the dense $TiO_2$ layer was formed was set on a spin coater (MS-100 manufactured by Mikasa Co., Ltd.), dust was blown off with a blower, the $TiO_2$ suspension (190 $\mu$L) was dropped with a micropipette to perform a spin coating (slope 5 s, 5000 rpm/30 s, slope 5 s). The residue of the $TiO_2$ suspension on the contact portion (non-etched side) between the four side surfaces and the FTO was wiped off with a cotton swab soaked with ethanol, and the FTO substrate was placed on a hot plate at 125°C, and then dried for 30 minutes. After that, the temperature was raised to 500°C over 1 hour and calcination was performed for 30 minutes to obtain a $TiO_2$-porous-layer-equipped FTO substrate.
Next, 0.5 mL of N,N-dimethylformamide (manufactured by Wako Pure Chemical Industries, Ltd., ultra-dehydrated, further dehydrated with molecular sieves) was added to a mixture of 369 mg of hexadecylammonium having 16 carbon atoms and 231 mg of $PbI_2$ (manufactured by Tokyo Chemical Industry Co., Ltd., lead (II) iodide 99.99%, trace metals basis for perovskite precursor), and the mixture was stirred on a hot stirrer at 70°C until dissolved to prepare a perovskite precursor solution. The $TiO_2$-porous-layer-equipped FTO substrate was set on a spin coater, and dust was blown off with a blower. Then, the perovskite precursor solution (150 $\mu$L) was applied onto the $TiO_2$-porous-layer-equipped FTO substrate, and after waiting for 5 seconds, spin coating was performed with the lid being open (slope 5 s, 6500 rpm/5 s, slope 5 s). Immediately after spin coating, the FTO substrate was placed on a hot plate at 70°C and dried for 30 minutes. Then, the FTO substrate was cooled to room temperature, thereby to form a layered perovskite (a light absorption layer containing $(C_{16}H_{33}NH_3)_2PbI_4$) on the $TiO_2$ porous layer.
Subsequently, 72.3 mg of Spiro-OMeTAD (manufactured by Wako Pure Chemical Industries, Ltd., 2,2',7,7'-tetrakis[N,N-di-p-methoxyphenylamino]-9,9'-spirobifluorene), 9.1 mg of LiTFSI (manufactured by Wako Pure Chemical Industries, Ltd., bis(trifluoromethanesulfonyl)imide lithium), 8.7 mg of Co(4-t-butylpyridyl-2-1H-pyrazole)$_3$.3TFSI (manufactured by Wako Pure Chemical Industries, Ltd., FK-209 ([tris(2-(1H-pyrazol-1-yl)-4-tert-butylpyridine) cobalt (III) tris(bis(trifluoromethylsulfonyl)imide)]), 1 mL of chlorobenzene (manufactured by Nacalai Tesque, Inc.) and 28.8 $\mu$L of TBP (manufactured by Sigma Aldrich) were mixed and stirred to prepare a Spiro-OMeTAD solution. Then, the Spiro-OMeTAD solution was filtered with a PTFE filter (0.45 $\mu$m). The substrate on which the layered perovskite (light absorption layer) was formed was set on a spin coater, dust was blown off with a blower, 90 $\mu$L of the Spiro-OMeTAD solution was applied onto the layered perovskite, and after waiting for 10 seconds, spin coating was performed (slope 5 s, 4000 rpm/30 s, slope 5 s). After that, the substrate was placed on a hot plate at 70°C and dried for 30 minutes to form a hole transport layer on the layered perovskite. Further, the back surface of this substrate was wiped with a cotton swab soaked with DMF and Kimwipes (manufactured by Nippon Paper Crecia Co., Ltd.). After that, the contact portion with the FTO was wiped off with a cotton swab soaked with chlorobenzene. Using a vacuum vapor deposition apparatus (VTR-060M/ERH, manufactured by ULVAC KIKO Inc.), a 2.5 cm gold wire (1 mm diameter, manufactured by The Nilaco Corporation) was placed on a tungsten board. Under a vacuum (4 to 5 x $10^{-3}$ Pa), the current value was adjusted so that the vapor deposition rate was 6 Å/sec, and gold was deposited on the hole transport layer until the film thickness reached 100 nm to form an electrode, thereby to obtain a solar cell.

Example 9

A solar cell was obtained in the same manner as in Example 8 except that 397 mg of octadecylammonium having 18 carbon atoms (a neutralized product of octadecylamine manufactured by Wako Pure Chemical Industries, Ltd. with hydroiodic acid manufactured by Wako Pure Chemical Industries, Ltd.) was used instead of using 369 mg of hexadecylammonium having 16 carbon atoms.

Comparative Example 7

A solar cell was obtained in the same manner as in Example 8 except that 201 mg of butylamine hydroiodide having 4 carbon atoms (manufactured by Tokyo Chemical Industry Co., Ltd.) was used instead of using 369 mg of hexadecylammonium having 16 carbon atoms.

Comparative Example 8

A solar cell was obtained in the same manner as in Example 8 except that 257 mg of octylamine hydroiodide having 8 carbon atoms (a neutralized product of octylamine manufactured by Wako Pure Chemical Industries, Ltd., Wako Special Grade with hydroiodic acid manufactured by Wako Pure Chemical Industries, Ltd.) was used instead of using 369 mg of hexadecylammonium having 16 carbon atoms.

[Table 1]

| | BASE LAYER | CONTACT ANGLE (GLYCERIN) | CONTACT ANGLE (DIIODOMETHANE) | SURFACE FREE ENERGY (mJ/m$^2$) | DISPERSION COMPONENT (mJ/m$^2$) | POLAR COMPONENT (mJ/m$^2$) |
|---|---|---|---|---|---|---|
| PRODUCTION EXAMPLE 1 | TiO$_2$ POROUS MATERIAL | 13.8 | 7.2 | 82.9 | 37.2 | 45.7 |
| PRODUCTION EXAMPLE 2 | PEDOT:PSS | 24.0 | 31.4 | 79.8 | 30.9 | 48.9 |
| PRODUCTION EXAMPLE 3 | Spiro-OMeTAD | 66.3 | 10.4 | 50.4 | 47.3 | 3.1 |

[Table 2]

| | EXAMPLE 1 | EXAMPLE 2 | EXAMPLE 3 | EXAMPLE 4 | EXAMPLE 5 | EXAMPLE 6 | EXAMPLE 7 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 |
|---|---|---|---|---|---|---|---|---|---|---|---|---|---|
| PEROVSKITE PRECURSOR | $C_{16}H_{33}NH_3I$ AND $PbI_2$ | $C_{16}H_{33}NH_3I$ AND $PbI_2$ | $C_{16}H_{33}NH_3I$ AND $PbI_2$/$PbBr_2$ | $C_{16}H_{33}NH_3I$ AND $PbI_2$ | $C_{18}H_{37}NH_3I$ AND $PbI_2$ | $C_{18}H_{37}NH_3I$ AND $PbI_2$ | $C_{18}H_{37}NH_3I$ AND $PbI_2$ | $C_4H_9NH_3I$ AND $PbI_2$ | $C_4H_9NH_3I$ AND $PbI_2$ | $C_4H_9NH_3I$ AND $PbI_2$ | $C_8H_{17}NH_3I$ AND $PbI_2$ | $C_8H$ $NH_3$ AND $PbI_2$ | $C_8H_{17}NH_3I)1$ AND $PbI_2$ |
| LAYERED PEROVSKITE | $(C_{16}H_{33}NH_3)_2 PbI_4$ | $(C_{16}H_{33}NH_3)_2 PbI_4$ | $(C_{16}H_{33}NH_3)_2 PbI_{3.2}Br_{0.8}$ | $(C_{16}H_{33}NH_3)_2 PbI_4$ | $(C_{18}H_{37}NH_3)_2 PbI_4$ | $(C_{18}H_{37}NH_3)_2 PbI_4$ | $(C_{18}H_{37}NH_3)_2 PbI_4$ | $(C_4H_9NH_3)_2 PbI_4$ | $(C_4H_9NH_3)_2 PbI_4$ | $(C_4H_9NH_3)_2 PbI_4$ | $(C_8H_{17}NH_3)_2 PbI_4$ | $(C_8H_{17}NH_3)_2 PbI_4$ | $(C_8H_{17}NH_3))_2 PbI_4$ |
| BASE LAYER | $TiO_2$ POROUS MATERIAL | PEDOT:PSS | PEDOT:PSS | Spiro-OMeTAD | $TiO_2$ POROUS MATERIAL | PEDOT:PSS | Spiro-OMeTAD | $TiO_2$ POROUS MATERIAL | PEDOT:PSS | Spiro-OMeTAD | $TiO_2$ POROUS MATERIAL | PEDOT:PSS | Spiro-OMeTAD |
| SURFACE FREE ENERGY ($mJ/m^2$) | 83 | 80 | 80 | 50 | 83 | 80 | 50 | 83 | 80 | 50 | 83 | 80 | 50 |
| BAND GAP (eV) | 2.4 | 2.4 | 2.5 | 2.4 | 2.4 | 2.4 | 2.4 | 2.3 | 2.3 | 2.3 | 2.3 | 2.3 | 2.3 |
| (002) INTER-SURFACE DISTANCE (nm) | 2.94 | 2.96 | 2.96 | 2.96 | 3.22 | 3.27 | 3.17 | 1.37 | 1.38 | 1.37 | 1.89 | 1.87 | 1.86 |
| (111) PLANE PEAK INTENSITY | 2182 | 3805 | 2710 | 2562 | 2032 | 2128 | 3339 | - | - | - | - | - | - |
| (002) PLANE PEAK INTENSITY | 18273 | 3187 | 11623 | 12030 | 30315 | 24009 | 30703 | 4428044 | 3779539 | 323067 | 274900 | 1153476 | 1294091 |

| | EXAMPLE 1 | EXAM-PLE 2 | EXAM-PLE 3 | EXAM-PLE 4 | EXAM-PLE 5 | EXAM-PLE 6 | EXAM-PLE 7 | COMPARA-TIVE EXAM-PLE 1 | COMPARA-TIVE EXAM-PLE 2 | COMPARA-TIVE EXAM-PLE 3 | COMPARA-TIVE EXAM-PLE 4 | COMPARA-TIVE EXAM-PLE 5 | COMPARA-TIVE EXAM-PLE 6 |
|---|---|---|---|---|---|---|---|---|---|---|---|---|---|
| INTENSI-TY RATIO (111)/(002) | 0.12 | 1.19 | 0.23 | 0.21 | 0.07 | 0.09 | 0.11 | 0 | 0 | 0 | 0 | 0 | 0 |
| ABSORPTION EDGE (nm) | 521 | 520 | 495 | 517 | 524 | 525 | 521 | 533 | 536 | 535 | 532 | 533 | 534 |

[Table 3]

|  | EXAMPLE 8 | EXAMPLE 9 | COMPARATIVE EXAMPLE 7 | COMPARATIVE EXAMPLE 8 |
|---|---|---|---|---|
| PEROVSKITE PRECURSOR | $C_{16}H_{33}NH_3I$ AND $PbI_2$ | $C_{18}H_{37}NH_3I$ AND $PbI_2$ | $C_4H_9NH_3I$ AND $PbI_2$ | $C_8H_{17}NH_3I$ AND $PbI_2$ |
| LAYERED PEROVSKITE | $(C_{16}H_{33}NH_3)_2 PbI_4$ | $(C_{18}H_{37}NH_3)_2 PbI_4$ | $(C_4H_9NH_3)_2 PbI_4$ | $(C_8H_{17}NH_3)_2 PbI_4$ |
| BASE LAYER | $TiO_2$ POROUS MATERIAL | $TiO_2$ POROUS MATERIAL | $TiO_2$ POROUS MATERIAL | $TiO_2$ POROUS MATERIAL |
| SURFACE FREE ENERGY (mJ/m$^2$) | 83 | 83 | 83 | 83 |
| BAND GAP (eV) | 2.4 | 2.4 | 2.3 | 2.3 |
| (002) INTER-SURFACE DISTANCE (nm) | 2.94 | 3.22 | 1.37 | 1.89 |
| (111) PLANE PEAK INTENSITY | 2182 | 2032 | - | - |
| (002) PLANE PEAK INTENSITY | 18273 | 30315 | 4428044 | 274900 |
| INTENSITY RATIO (111)/(002) | 0.12 | 0.07 | 0 | 0 |
| ABSORPTION EDGE (nm) | 521 | 524 | 533 | 532 |
| SHORT-CIRCUIT CURRENT DENSITY (mA/cm$^2$) | 0.45 | 0.29 | 0.07 | 0.10 |
| OPEN CIRCUIT VOLTAGE (V) | 0.44 | 0.41 | 0.47 | 0.53 |
| FILL FACTOR (ff) | 0.56 | 0.46 | 0.38 | 0.39 |
| CONVERSION EFFICIENCY (%) | 0.11 | 0.05 | 0.01 | 0.02 |
| IPCE (%) (AT 400 nm) | 20.6 | 11.7 | 3.0 | 2.2 |

From Table 3, it can be seen that the solar cell of Example 8 or 9 having a light absorption layer containing a layered perovskite having an intensity ratio ((111) plane/(002) plane) of 0.12 or 0.07 is more excellent in photoelectric conversion efficiency and quantum efficiency as compared with the solar cell of Comparative Example 7 or 8 having a light absorption layer containing a layered perovskite having an intensity ratio ((111) plane/(002) plane) of 0.

INDUSTRIAL APPLICABILITY

The layered perovskite of the present invention is useful as a light absorption layer of a solar cell. More specifically, the light absorption layer including the layered perovskite, the photoelectric conversion element, and the solar cell of the present invention are excellent in carrier transport capacity of the light absorption layer (layered perovskite layer) and have a large band gap, so that an excellent energy conversion efficiency can be realized. Further, the absorption wavelength can be controlled, so that a solar cell having excellent coloring property can be provided. The light absorption layer and the photoelectric conversion element according to the present invention can be suitably used as constituent members of a next-generation solar cell.

DESCRIPTION OF REFERENCE SIGNS

1    Photoelectric conversion element
2    Transparent substrate
3    Transparent conductive layer
4    Blocking layer
5    Electron extraction layer
6    Light absorption layer
7    Hole transport layer
8    Electrode (positive electrode)
9    Electrode (negative electrode)
10   Light
11   Charge transport layer
12   Organic layer
13   Electrode substrate

**Claims**

1.  A layered perovskite, wherein an inter-surface distance of (002) planes calculated from an X-ray diffraction peak obtained by an out-of-plane method is 2.6 nm or more and 5.0 nm or less, and, in the X-ray diffraction peak, an intensity ratio ((111) plane/(002) plane) of an X-ray diffraction peak intensity at a (111) plane with respect to an X-ray diffraction peak intensity at the (002) plane is 0.03 or more.

2.  The layered perovskite according to claim 1, containing a compound represented by the following general formula (1):

$$R_2MX^1_nX^2_{4-n} \qquad (1)$$

wherein R is a monovalent cation, two Rs are identical to each other, M is a divalent metal cation, $X^1$ and $X^2$ are each independently a monovalent anion, and n is an average number of moles of $X^1$, and n is a real number of 0 or more and 4 or less.

3.  The layered perovskite according to claim 2, wherein R is an alkylammonium ion having 14 to 30 carbon atoms.

4.  The layered perovskite according to claim 2 or 3, wherein $X^1$ and $X^2$ are each independently a fluoride anion, a chloride anion, a bromide anion, or an iodide anion.

5.  The layered perovskite according to any one of claims 2 to 4, wherein M is one or more metal cations selected from the group consisting of $Pb^{2+}$, $Sn^{2+}$, and $Ge^{2+}$.

6.  The layered perovskite according to any one of claims 1 to 5, having a band gap energy of 2.0 eV or more and 3.5 eV or less.

7.  A light absorption layer containing the layered perovskite according to any one of claims 1 to 6.

8.  A light-absorption-layer-equipped substrate, wherein the light absorption layer according to claim 7 is formed on a substrate having a surface free energy of 40 $mJ/m^2$ or more and 100 $mJ/m^2$ calculated by using the Owens-Wendt equation.

9.  A photoelectric conversion element having the light absorption layer according to claim 7 or the light-absorption-layer-equipped substrate according to claim 8.

10. A solar cell having the photoelectric conversion element according to claim 9.

Fig.1

11
12
11
12
11
13

Fig.2

12     12
11     11     11

13

Fig.3

## INTERNATIONAL SEARCH REPORT

| International application No. |
|---|
| PCT/JP2018/023251 |

**A. CLASSIFICATION OF SUBJECT MATTER**
Int. Cl. H01L51/44(2006.01)i

According to International Patent Classification (IPC) or to both national classification and IPC

**B. FIELDS SEARCHED**

Minimum documentation searched (classification system followed by classification symbols)
Int. Cl. H01L51/42-51/48

Documentation searched other than minimum documentation to the extent that such documents are included in the fields searched
Published examined utility model applications of Japan    1922-1996
Published unexamined utility model applications of Japan  1971-2018
Registered utility model specifications of Japan          1996-2018
Published registered utility model applications of Japan  1994-2018

Electronic data base consulted during the international search (name of data base and, where practicable, search terms used)
CAplus/REGISTRY (STN), Wiley Online Library, ACS PUBLICATIONS, Scitation

**C. DOCUMENTS CONSIDERED TO BE RELEVANT**

| Category* | Citation of document, with indication, where appropriate, of the relevant passages | Relevant to claim No. |
|---|---|---|
| Y | SANEHIRA, Yoshitaka et al., "Photovoltaic Properties of Two-dimensional $(CH_3(CH_2)_3NH_3)_2PbI_4$ Perovskite Crystals Oriented with $TiO_2$ Nanowire Array", Chemistry Letters, 2017, vol. 46, pp. 1204-1206, in particular, fig. 2, 4, table 1 | 1-10 |
| Y | AHMAD, Shahab et al., "Direct deposition strategy for highly ordered inorganic organic perovskite thin films and their optoelectronic applications", OPTICAL MATERIALS EXPRESS, 2014, vol. 4, no. 7, pp. 1313-1323, in particular, pp. 1318, p.1323 | 1-10 |

☒ Further documents are listed in the continuation of Box C.      ☐ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 15.08.2018 | 28.08.2018 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

International application No.

PCT/JP2018/023251

C (Continuation).   DOCUMENTS CONSIDERED TO BE RELEVANT

| Category* | Citation of document, with indication, where appropriate, of the relevant passages | Relevant to claim No. |
|---|---|---|
| Y | TRAORE, Boubacar et al., "Composite Nature of Layered Hybrid Perovskites: Assessment on Quantum and Dielectric Confinements and Band Alignment", ACS Nano, 26 February 2018, vol. 12, pp. 3321-3332, in particular, abstract, fig. 4 | 1-10 |
| Y | NIU, Yuwei et al., "Aggregation-lnduced Emission Features of Organometal Halide Perovskites and Their Fluorescence Probe Applications", ADVANCED OPTICAL MATERIALS, 2015, vol. 3, pp. 112-119, in particular, abstract | 1-10 |
| Y | PRADEESH, K. et al., "Synthesis, structural, thermal and optical studies of inorganic-organic hybrid semiconductors, R-Pbl$_4$", JOURNAL OF APPLIED PHYSICS, 2013, vol. 113, p. 083523-1 to p. 083523-9, in particular, table 1, 3 | 1-10 |
| Y | WO 2018/025445 A1 (KAO CORP.) 08 February 2018, paragraphs [0017]-[0030], [0066]-[0124], fig. 1 (Family: none) | 1-10 |
| A | JP 2016-92293 A (FUJIFILM CORP.) 23 May 2016 (Family: none) | 1-10 |

Form PCT/ISA/210 (continuation of second sheet) (January 2015)

**REFERENCES CITED IN THE DESCRIPTION**

**Patent documents cited in the description**

- WO 2017086337 A
- JP 2016063090 A
- JP 2017005196 A

**Non-patent literature cited in the description**

- *JACS,* 2015, vol. 137, 7843-7850
- *Chemical Review,* 2010, vol. 110, 6595